# EUROPEAN PATENT APPLICATION

(11) **EP 4 742 544 A1**
(43) Date of publication of application: **13.05.2026**
(21) Application number: 25212980.4
(22) Date of filing: 03.11.2025
(51) Int. Cl.: H03M 13/11, H03M 13/37, H03M 13/00, H04L 1/00, H04Q 11/00, H03M 13/33, H03M 13/15, H03M 13/45

(54) **CONDITIONALLY PROCESSING COMPUTE RESOURCES**

(30) Priority: 06.11.2024 US 202463716802 P
(71) Applicant: CALIX, INC., San Jose, CA 95117 (US)
(72) Inventor: BERNARD, Christopher, Thomas, Minneapolis, 55410 (US); NOTCH, Scott, Hanover, 55341 (US)
(74) Representative: Murgitroyd & Company

(57) **Abstract**

Systems and techniques for conditionally processing compute resources are described herein. A data payload is received. Parity data is removed from the data payload to generate a codeword dataset. Frames are identified in the codeword dataset. Headers of the frames are evaluated using a conditional decoding map. The frames are marked based on a destination in the headers found in the conditional decoding map. A set of target codewords are identified from the frames based on the marking. Remaining frames of the frames outside the set of target codewords are discarded. The set of target codewords is transmitted to a buffer of a conditional decoder. Codewords from the buffer are decoded using the conditional decoder.

## Description

This application claims the benefit of priority to U.S. Provisional Patent Application Serial No. 63/716,802, filed on November 6, 2024.

### TECHNICAL FIELD

Embodiments described herein generally relate to network processing power consumption reduction and, in some embodiments, more specifically to forward error correction power conservation.

### BACKGROUND

Low density parity check forward error correction (LDPC-FEC) can be used to determine network data error rates. LDPC-FEC can encode data resulting in processing power (e.g., electric energy) usage to encode and decode data. In some instances, decoding can be responsible for more than half of the processing workload and power consumption of a networking device. Network standards bodies have sought to improve the energy impact of operating access networks. Worldwide energy crises have a renewed the call to implement reduced energy consumption in networking hardware executing as central office (CO) equipment and as customer premise equipment (CPE).

### SUMMARY

The invention is a system, method and machine-readable medium as defined in the appended claims.

### BRIEF DESCRIPTION OF THE DRAWINGS

In the drawings, which are not necessarily drawn to scale, like numerals can describe similar components in different views. Like numerals having different letter suffixes can represent different instances of similar components. The drawings illustrate generally, by way of example, but not by way of limitation, various embodiments discussed in the present document.
FIG. 1 illustrates an example of a relation between power consumption and throughput for typical optical network unit (ONU) and a relation between power consumption and throughput for an ideal ONU.
FIG. 2 is a block diagram of an example of an environment and a system for conditional codeword decoding, according to an embodiment.
FIG. 3 illustrates a flow diagram of an example of downstream service data unit (SDU) mapping into physical layer (PHY) frames.
FIG. 4 is a block diagram of an example of an environment and a system for conditionally processing compute resources, according to an embodiment.
FIG. 5 illustrates an example of a process for ten gigabit passive optical network (XGPON) Encapsulation Method (XGEM) look-ahead for conditionally processing compute resources, according to an embodiment.
FIG. 6 illustrates and example of a framing sublayer (FS) packet for conditionally processing compute resources, according to an embodiment.
FIG. 7 illustrates and example of a ten gigabit passive optical network (XGPON) Encapsulation Method (XGEM) packet for conditionally processing compute resources, according to an embodiment.
FIG. 8 illustrates an example of a reduced operations process for ten gigabit passive optical network (XGPON) Encapsulation Method (XGEM) look-ahead for conditionally processing compute resources, according to an embodiment.
FIG. 9 is a flow diagram of an example method for conditionally processing compute resources, according to an embodiment.
FIG. 10 is a block diagram of an example network interface device for conditionally processing compute resources, according to an embodiment.
FIG. 11 is a block diagram of an application specific integrated circuit (ASIC) for conditionally processing compute resources, according to an embodiment.
FIG. 12 is a block diagram of frame reconstruction of an example frame for conditionally processing compute resources, according to an embodiment.
FIG. 13 is a block diagram of that illustrates decoding operations for various packet configurations for conditionally processing compute resources, according to an embodiment.
FIG. 14 is a flow diagram of an example method for conditionally processing compute resources, according to an embodiment.
FIG. 15 is a block diagram illustrating an example of a machine upon which one or more embodiments can be implemented.

### DETAILED DESCRIPTION

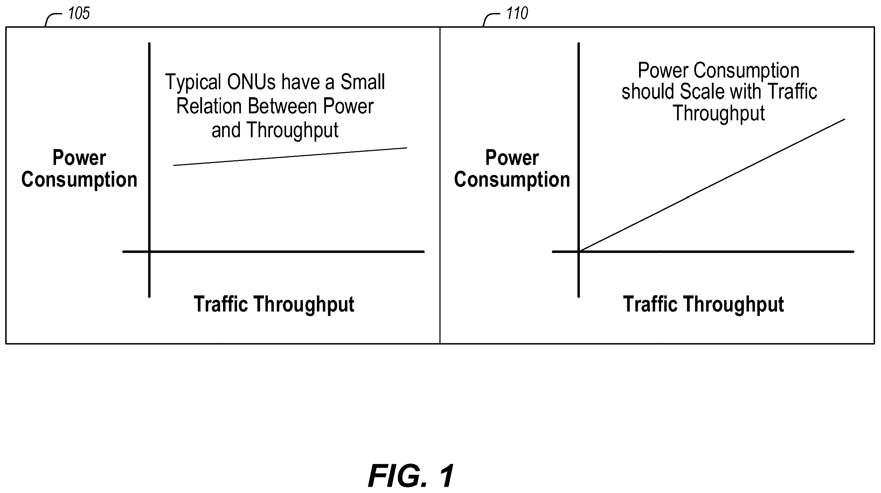

FIG. 1 illustrates an example of a relation between power consumption and throughput for typical optical network unit (ONU) 105 and a relation between power consumption and throughput for an ideal ONU 110. As shown in FIG. 1, for the typical ONU 105, there is little power savings achieved when traffic stops flowing. The ideal ONU 110 illustrates power going to a minimal amount when there is no traffic. The systems and techniques described herein measurably increase the power consumption to throughput slope of the typical ONU 105 to approach the ideal ONU 110.

The systems and techniques described herein make modification to a passive optical network transmission convergence (PON-TC) layer to achieve better power/traffic correlation. International Telecommunication Union (ITU) and Institute of Electrical and Electronics Engineers (IEEE) PON-TC layers beyond physical layer (PHY) rates of 10 gigabits (Gbs) use more advanced forward error correction (FEC) coding gain to meet industry accepted optical distribution network (ODN) link budgets. In the ITU (G.9804.2) High-Speed PON standard, low density parity check (LDPC) codes have been adopted to replace Reed-Solomon codes used in gigabit-capable passive optical network (GPON) and symmetric 10-gigabit passive optical network (XGS-PON). LDPC FEC provides improved coding gain to offset the higher error-rate caused by pushing lasers/receivers to their theoretical limits.

An ONU implementing a 50Gbs LDPC FEC decoder utilizes a tremendous amount of processing power. According to application specific integrated circuit (ASIC) vendors, it is estimated that 60-70% of the PON TC layer power is due to the FEC decoder function-on the order of 750mW in a 5nm process technology. Soft-decision FEC can be used to meet some link budgets which can increase computational power by a factor of two since the FEC decoder acts upon not only the recovered data, but also on a probability vector describing the likelihood that a given bit was sample wrong.

Point-to-multipoint network optical network terminals (ONTs) receive and decode all downstream traffic and filter out a small subset that is destined for the subscriber subtended from the ONT. Consider the entirety of the ODN-128 ONTs all decoding 50Gbs of LDPC FEC-resulting in a set of ASICs collectively decoding (128 * 50Gbs = 6.4 terabits (Tbs)) of traffic-even though at most 50Gbs is actually processed as user traffic. From a power dissipation perspective power consumption is (750mW * 128 = 96W) due to the FEC decoding across the ODN.

The systems and techniques described herein provide a standards-based technique that allows an ONU to only decode FEC codewords that contain traffic destined for that ONU, such that other codewords can be paused translating into substantial power savings across an ODN. This results in an estimated 98% power savings across an ODN-which scales to 73W per 100 ONTs. This scales to a substantial amount considering a future 50G-PON lifetime scale of 100M endpoints resulting in up to 73MW of power savings.

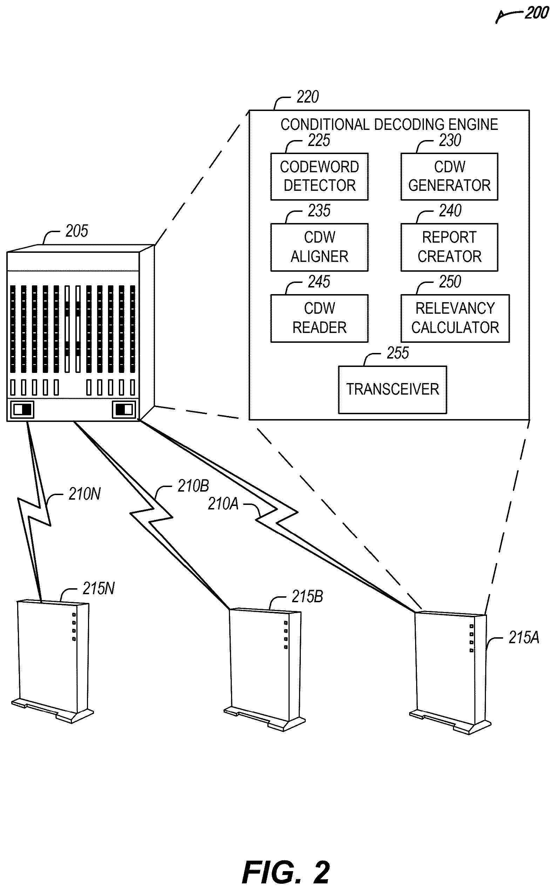

FIG. 2 is a block diagram of an example of an environment 200 and a system 220 for conditional codeword decoding, according to an embodiment. The example environment 200 includes an optical line terminal (OLT) 205 that is connected via optical links 210A, 210B, and 210N to optical network units (ONUs) 215A, 215B, and 215N. The OLT 205 and the ONUs 215A, 215B, and 215N can include the system 220. In an example, the system 220 is a conditional decoding engine. The example system 220 includes a codeword detector 225, a conditional decoding window (CDW) generator 230, a CDW aligner 235, a report creator 240, a CDW reader 245, a relevancy calculator 250, and a transceiver 255.

ITU based PON transports encapsulate user traffic within a construct called 10-gigabit-capable PON encapsulation method (XGEM). XGEM encapsulation allows traffic to be fragmented and separated by service. XGEM headers contain the size of the frame such that a receiver can delineate the incoming traffic and filter only those fragments that are intended for this receiver. XGEM fragments are of variable size such that the receiver tracks and verify the position of the next header on an on-going basis-a technique referred to here as XGEM delineation.

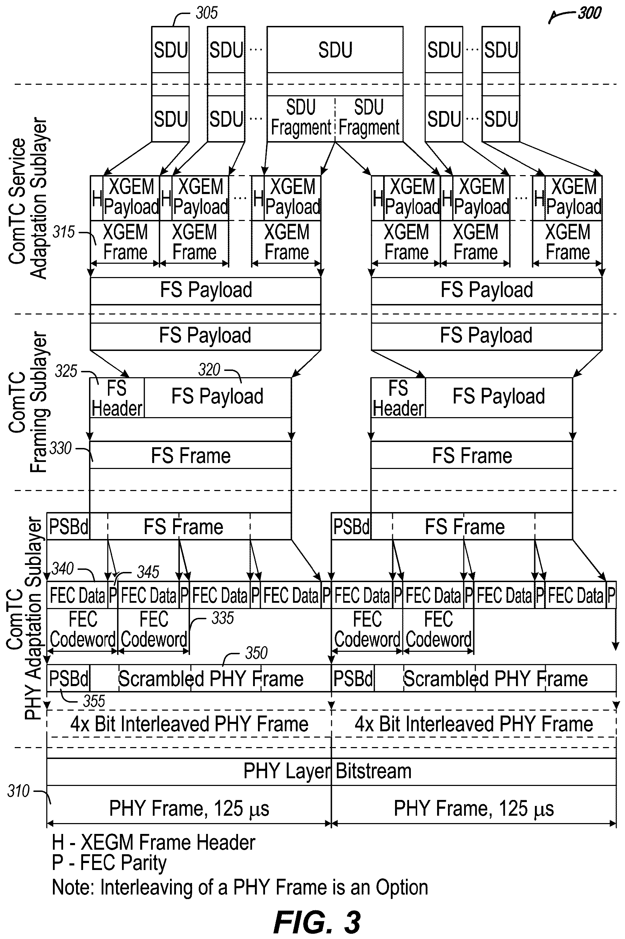

FIG. 3 illustrates a flow diagram 300 of an example of downstream service data unit (SDU) 305 mapping into physical layer (PHY) frames 310. A PON TC layer begins with a service adaption of service data units (SDUs) 305 (e.g., user data) into a series of XGEM encapsulated fragments 315. These are mapped to a framing sublayer (FS) payload 320, which along with an FS header 325 represent an FS Frame 330 that carries traffic to an ONU. The FS frame is broken into a series of FEC codewords 335 comprised of a data portion 340 and a parity portion 345 calculated by the FEC encoder. The FEC decoder uses the parity 345 to correct any bits that were transmitted with errors in the codeword 335, up to ~1E-2 bit-error-rate. The FEC codewords 335 are then scrambled/interleaved 350 and sent every 125µs along with a physical synchronization block (PSBd) 355 that an ONU recovers to maintain downstream synchronization.

Returning to the description of FIG. 2, when an ONU (e.g., ONUs 215A, 215B, 215N, etc.) receives data at a higher error-rate than the FEC decoder can correct, loss of XGEM delineation occurs. If an ONU decides to not decode some of the codewords, it is expected that this would also lead to a loss of XGEM delineation. The XGEM state machine sees some number of valid XGEM headers in a row before it declares XGEM-lock-such that data loss can be expected for a few packets even when the proper error-rate has been restored.

In order for an ONU to selectively ignore certain codewords, two factors are considered: (1) the concept of a conditional decoding window with guaranteed XGEM delineation at the beginning and (2) a method to convey to the ONU which XGEM headers apply to a conditional decoding window.

The examples used herein refer to use in 50G-PON (ITU standard G.9804.3) however, the system 220 can operate similarly in a variety of networks that use forward error correction such as, by way of example and not limitation, other PON systems, wireless networks, Ethernet networks, and other networks that use LDPC-FEC or other form of forward error correction. For example, a system utilizing a block-FEC (rather than packet based) is suitable for applicability, including 25GS-PON, 802.3ca 25G EPON, 10-gigabit-capable PON (XG-PON), 10-gigabit-capable symmetric PON (XGS-PON), and future very-high-speed-PON (G.VHSP).

A new construct in the PON-TC layer is generated by the CDW generator 230 called a conditional decoding window (CDW) comprised of a configurable number of FEC codewords detected by the codeword detector 225. The CDW represents a portion of the PON-TC that an ONU can choose to ignore. A CDW can encompass an entire PON-TC frame (125 µs) or could be broken up into many CDWs per frame. In an example, a configurable parameter for the CDW configuration is set by the OLT and honored by a compliant ONT.

### Characteristics of a CDW

A new CDW is aligned with the beginning of a new FEC codeword. The OLT 205 aligns XGEM delineation to the beginning of a new CDW such that the ONUs 215A, 215B, and 215N have immediate XGEM delineation if the previous CDW was not being processed. The end of a CDW contains either a full fragment up to the end, or an IDLE frame aligned to the end. A new CDW aligns with the beginning of a PON-TC frame and contain a pointer to the beginning of the first conditional section. The last CDW in a PON frame can have fewer codewords. An ONU that is not compliant observes legal XGEM framing and maintains XGEM delineation throughout the PON-TC frame. The ONUs 215A, 215B, and 215N decode the first codeword of the PON-TC frame to determine whether additional codewords are to be decoded before the FS payload begins.

The codeword detector 225 identifies a first codeword in a network transmission. In an example, the network transmission is a passive optical network transmission convergence (PON-TC). The CDW generator 230 generates a conditional decoding window that begins with the first codeword. In an example, a codeword count can be determined for the conditional decoding window. Additional codewords can be added to the conditional decoding window until the codeword count is reached. The additional codewords sequentially following the first codeword in the network transmission. In an example, it can be determined that the additional codewords are insufficient to reach the codeword count and an idle frame can be added to the conditional decoding window to reach the codeword count.

The CDW aligner 235 aligns the conditional decoding window with a frame of the network transmission. In an example, the CDW aligner 235 can delineate the frame to generate a delineation point and the conditional decoding window is aligned with the delineation point.

### CDW Report Format

A CDW aware ONU (e.g., ONUs 215A, 215B, and 215N) can determine whether to ignore certain CDWs based upon whether the traffic within applies to itself. In order to make this decision, the OLT 205 sends a report that conveys the content of the current CDW, herein referred to as a 'CDW Report'. For example, a CDW-report-downstream (CDWRd) can be transmitted to an ONU. The content of the report can be sent a number of different ways allowing the ONU to determine whether to process the CDW or safely ignore and resume on the next CDW.

A low-precision CDW report format can be the simplest report format and easiest to implement. The report can be sent as a single binary bit to each ONU specifying whether the current CDW is relevant to each ONU 215A, 215B, and 215N. The report can be encapsulated at the beginning of the CDW and can contain one-bit-per ONU-128b total in addition to the XGEM header. The ONU makes decoding decisions per CDW. The ONU would have no visibility into which of the CDW codewords carries the data-only that it is located somewhere and the codewords should be decoded. The OLT is responsible for assembling an XGEM to ONU map for the entire CDW and encapsulating the map into a reserved XGEM frame.

This is considered a 'low precision' report as it only specifies an ONT to decode or ignore an entire CDW. If the window is large it is likely that the ONU is decoding codewords that have no relevant traffic. This method is appropriate for the 'low power, no traffic' modes, but during times of high traffic across many services, the entirety of the PON can be decoding much more than necessary. Low-precision formatting offers a tradeoff between complexity and efficiency.

A high-precision CDW report format can send each compliant ONU a list of codewords within the CDW that apply. Each code word within the CDW can have a binary decode/ignore flag per ONU. High-precision formatting is the most efficient in that the ONU knows exactly which codewords to process and which to ignore within a CDW, but comes at the cost of higher complexity and overhead.

A variable-precision CDW report format can send high-precision report content to only those ONTs which can substantially benefit and offers a balance between efficiency and overhead. The low precision report is sent followed by some number of high-precision reports at the discretion of the OLT 205 with the intent of minimizing report size while maximizing codeword efficiency. ONUs that have minimal codewords to process in a CDW would be sent a high-precision report while ONUs that have many code words to process would rely on the low-precision report. Variable size report formatting can send reports only to ONUs with active traffic flows.

Multiple examples are provided for how a codeword report could be formatted; low precision, high precision, or variable precision (as a combination of the two previous forms). In an example, a codeword report can be a report that utilizes lossless compression to reduce overhead of the report regardless of the precision of the report. Minimizing the report size reduces bandwidth utilization. The use of lossless compression provides reduced report size leading to reduced bandwidth utilization. It should be understood that a variety of techniques can be used to reduce the size of the reports while maintaining integrity of the report data to reduce bandwidth utilization.

Variable formatting can be complex to create and can be non-deterministic in its overhead the more traffic flows, the more overhead.

An XGEM-list CDW report format can send a discrete list of XGEM-IDs contained within the CDW. The advantage of the XGEM-list format is that the OLT 205 sends a list and lets each ONU decide whether the information within is relevant for its conditional decoding decision.

The report creator 240 generates a report that includes an indication of relevance of the conditional decoding window to a network device (e.g., the ONUs 215A, 215B, and 215N). In an example, the report creator 240 can create a binary indicator of the relevance of the conditional decoding window to the network device for inclusion in the report. In an example, the report creator 240 can generate a list of codewords included in the conditional decoding window and assign a binary indicator of the relevance of each codeword in the list of codewords to the network device for inclusion in the report. In an example, the report generator 240 can determine that network device is experiencing increased traffic volume and can include the list of codewords and the binary indicator of the relevance of each codeword in the report before transmission to the network device.

Example bandwidth utilization for the CDWRd using various CDW formats can include: Low Precision, CDW-Size = 16 Overhead = 35 Mbs (Gets smaller with larger CDW-Size); High Precision, CDW-Size = 16 Overhead = 412 Mbs (Every ONT gets a report for every code word. Independent of CDW-Size); Variable Precision, CDW-Size = 16 Overhead = 200 Mbs? (Dependent on a number of active streams). As discussed above, the reports can be containerized at various levels and compression can be used to reduce the size of the CDWs and reports.

### CDWRd Conveyance Mechanisms

The CDW Report is sent using a standards-based construct including, by way of example and not limitation, XGEM based conveyance, physical layer operation administration and maintenance (PLOAM) based conveyance, internet protocol (IP) based conveyance, and PON-TC protocol conveyance.

XGEM Based Conveyance: One option for sending the CDW report is to reserve an XGEM-ID dedicated to this function. XGEM is suitable for a high-bandwidth real-time protocol such as the proposed CDW-Reports. At the beginning of a CDW, the first XGEM can contain the CDW report. Compliant ONUs 215A, 215B, and 215N subscribed to this XGEM use this information to assemble a map of codewords within the CDW that can be safely ignored resulting in a temporary power savings. Non-compliant ONUs ignore the contents because they are not subscribed to this XGEM service and would process all codewords as normal.

PLOAM based Conveyance: PLOAM messages are used to send information between the OLT 205 and ONUs 215A, 215B, and 215N. It is possible to construct a new PLOAM message that can carry a CDW report. PLOAM messages occur at the beginning of a PON frame meaning the CDW can only be one-frame that can be too large due to added latency. Additionally, PLOAM messages are typically handled by a software process and are not suitable for high-bandwidth real-time information.

IP based Conveyance: The CDW is a PON-TC layer construct and can use a conveyance method at this level for ITU based PONs. Ethernet PONs rely on link-layer Ethernet protocols for real-time messaging. The CDW report can be transmitted by sending the CDW report in a link-layer Ethernet frame.

PON-TC Protocol Conveyance: A new TC layer field can be constructed to include a downstream report to the ONU indicating which codewords are relevant and which can be ignored. This can utilize existing constructs such that the technique can be implemented without changing in-force standards. Future PON standard yet to be written can include such constructs native to the TC layer that can be modified to accommodate CDW report transmission.

The transceiver 250 transmits the conditional decoding window and the report to the network device. In an example, the transceiver 250 can obtain a ten-gigabit capable encapsulation identifier (XGEM-ID) and the report can be transmitted using the XGEM-ID. In an example, the transceiver 250 can generate a physical layer operation administration and maintenance (PLOAM) message and the report can be transmitted within the PLOAM message. In an example, the transceiver 250 can generate a link-layer Ethernet frame and the report can be transmitted within the link-layer Ethernet frame. In an example, the transceiver 250 can generate a transmission convergence (TC) field and the report can transmitted within the TC field.

### CDW Size

ITU standard G.9804.3 defines a FEC code word using an LDPC (17280,14592). Each code word is 2160 octets in length of which 336 octets are parity. There are 360 codewords that comprise a frame in a G.9804.3 compliant TC. In order to convey the CDW map to the ONT it looks ahead at the XGEM-IDs in flight and send sufficiently prior such that the ONT can make its conditional decoding decision. A look ahead is another way of describing a buffer. In order to control the added latency of this conveyance buffer, the OLT can decide to utilize a small CDW (e.g., 8 codewords). With smaller CDWs come potentially larger overheads due to XGEM delineation as well as the conveyance content. In an example, the size can be configurable from 1 codeword up to a full 360 codeword frame. In an example, the CDW generator 230 can determine a codeword count for the conditional decoding window and the transceiver 255 can transmit the codeword count to the network device.

### Considerations for the Beginning of a PON-TC Frame

Normally an ONU only decodes the first codeword of a CDW to receive the report and determine decoding needs for the window. In the case of the first CDW of a PON-TC frame there are other factors to consider. The beginning of the PON frame contains critical information such as PLOAM messages, upstream bandwidth maps, and other framing information. ONUs process the FS header that can span greater than a single codeword. Early in the frame is a description of the size of the PLOAM / upstream bandwidth map (BWmap) partition such that a compliant ONU can determine how many of the initial codewords to process. This unique case applies to the first CDW in a PON-TC frame.

### Reporting an ONU's CDW Feature Capability

A new ONT management control interface (OMCI) management information block (MIB) element is added that allows an ONT to declare its capability with regard to the CDW. Ethernet PON standards use alternate link-layer messaging protocols to declare capability.

CDW-reports can be sent to ONUs without learning their capability because the protocol is backwards compatible with the standards. This trades efficiency to simplify the OLT without any changes to management / provisioning. A compliant OLT sends the reports in their entirety and rely on an ONUs compliance to support CDW compatibility or ignore CDW reports in the case of a non-compliant ONU.

### Backwards Compatibility and Interoperability

If both an OLT and an ONU are compliant, the compliant OLT learns of the ONUs capability through MIB upload and send the CDW size over OMCI, as well as a real-time CDW report for the purposes of conditional FEC decoding.

If the OLT is compliant and the ONU is non-compliant, ONUs that do not report a CDW capability processes FEC codewords as normal and maintain XGEM delineation as normal. The compliant OLT terminates XGEM frames, sends an XGEM CDW report, and resumes XGEM frames on CDW/FEC codeword boundaries. A non-compliant ONU observes these as normal XGEM frames and ignores the CDW report port-ID. Non-compliant ONUs can safely exist with compliant ONUs because there is no change to the G.9804.3 specification compliance of the TC-layer.

If the OLT is non-compliant and the ONU is compliant, the non-compliant OLT ignores the ONUs capability and processes TC frames as normal. ONUs do not receive a CDW report and therefore does not disable decoding.

If both the OLT and the ONU are non-compliant, they operate using standard TC operation per G.9804.3.

While the examples refer to downstream ONUs, the OLT has a FEC decoder. Because there is only one per PON, any savings offered by allowing the OLT to ignore codewords would be minimal. There is no need to conditionally process because the mere presence of an ONU burst implies that it is traffic bearing.

The transceiver 255 receives a conditional decoding window including a first codeword that is identified by the CDW reader 245. The relevancy calculator 250 obtains a report that includes a codeword relevance bit for the first codeword. Upon determination by the relevancy calculator 250 that the codeword relevance bit indicates that the first codeword is irrelevant, the first codeword is discarded without decoding the first codeword. If the relevancy calculator 250 determines that the codeword is relevant, the codeword is decoded.

In an example, the relevancy calculator 250 can receive a codeword count for the conditional decoding window. The relevancy calculator 250 can determine that a set of codewords including the first codeword contained in the conditional decoding window are irrelevant based on the codeword count and the codeword relevance bit and can discard the conditional decoding window without decoding the set of codewords.

In an example, the relevancy calculator 250 can subscribe to a ten-gigabit capable encapsulation identifier (XGEM-ID) published on a network. The relevancy calculator 250 can receive the report based on the XGEM-ID. The relevancy calculator 250 can generate a map of a set of codewords in the conditional decoding window, determine that a first subset of the set of codewords is relevant using the report, determine that a second subset of the set of codewords is irrelevant using the report. The relevancy calculator 250 can decode the first subset of the set of codewords and discard the second subset of the set of codewords without decoding.

In an example, the relevancy calculator 250 can receive a physical layer operation administration and maintenance (PLOAM) message and can obtain the report from the PLOAM message. In an example, the relevancy calculator 250 can receive a link-layer Ethernet frame and can obtain the report from the link-layer Ethernet frame. In an example, the relevancy calculator 250 can identify a transmission convergence (TC) field in a network transmission and can obtain the report from the TC field.

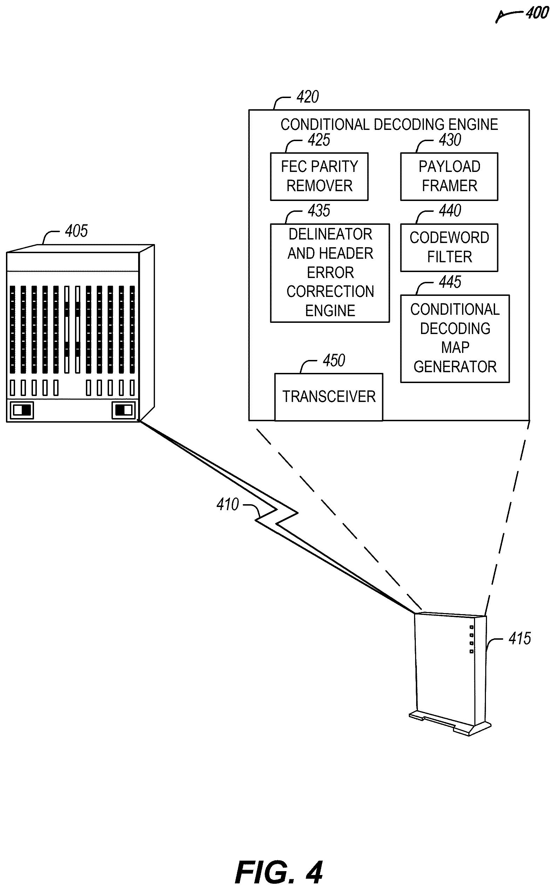

FIG. 4 is a block diagram of an example of an environment 400 and a system 420 for conditionally processing compute resources, according to an embodiment. The example environment 400 includes an optical line terminal (OLT) 405 that is connected via an optical link 410 to an optical network unit (ONU) 415. The ONU 415 can include the system 420. In an example, the system 420 is a conditional decoding engine. The example system 420 includes an FEC parity remover 425, a payload framer 430, a delineator and header error correction engine 435, a codeword filter 440, a conditional decoding map generator 445, and a transceiver 450.

A packet in a PON system can refer to a subscriber frame that is carried within an XGEM payload. As used herein, packet header refers to an error-correction-protected encapsulation header (e.g., an XGEM header, etc.) rather than a subscriber packet itself. The encapsulation header information is used to generate the conditional decoding maps. XGEM headers are used as an example of an error-correction-protected encapsulation header, but it should be understood that the systems and techniques discussed herein as applicable to a variety of other transport protocols.

A data is received via the transceiver 450 and is processed by the FEC parity remover 425. A pre-determined FEC algorithm or codeword size is used to remove parity from the data. The remaining data is an uncorrected copy of the original data with errors determined by the physical link. While the errors are unsuitable for recovering user traffic, enough information remains to continue processing a conditional decoding map.

The payload framer 430 utilizes the correctable header present in framing sublayer (FS) Header data to frame the data. Even though the FEC decoding has not been processed, the FS header itself has error correction built-in such that the ONT 415 has a high likelihood of correcting the field and properly framing the FS Payload in the presence of uncorrected data.

When the FS Payload has been recovered by the payload framer 430, the delineator and header error correction engine 435 (e.g., an XGEM delineation state machine, etc.) begins tracking XGEM headers that contain variable size payloads. Within an XGEM header is a HEC field that allows two-bit error correction, three-bit error detection, etc. The delineator and header error correction engine 435 maintains delineation in the presence of variable header positions. Although the payload of the XGEM frame is corrupted due to a lack of FEC decoding, XGEM header delineation is maintained in the presence of physical layer errors because the payload size and position of a subsequent XGEM frame is protected and correctable. XGEM payloads can be encrypted but are not relevant because the headers are used by the conditional decoding map generator 445 to create a conditional decoding map.

When the delineator and header error correction engine 435 has identified the frames, XGEM-IDs of the frames are checked against a lookup table by the codeword filter 440 to specify whether a port-id of the XGEM-ID is destined for the ONT 415 or if the codeword can be discarded as destined for a port-id of a different ONT. The underlying payload can be reassembled and reconstructed into the original SDU, but because the data is uncorrected by FEC, the original SDU is corrupted and unusable. Because the XGEM headers are correctable in the presence of no FEC decoding, the port-id information can still be used for the lookup table.

The output of the codeword filter 440 is the result of a lookup table specifying whether the current XGEM (and therefore the current FEC codeword) has relevant data for the ONT 415 generated by the conditional decoding map generator 445. The codeword is marked as relevant and fed to the standards-based processing path by the transceiver 450 with additional information for processing the frame. Matches that span codeword boundaries have both codewords marked as relevant. When no lookups occur within a codeword it is marked as nonrelevant, skip, etc. and is not processed by the FEC decoder reducing power consumption and processor utilization leading to reduced ASIC sizing.

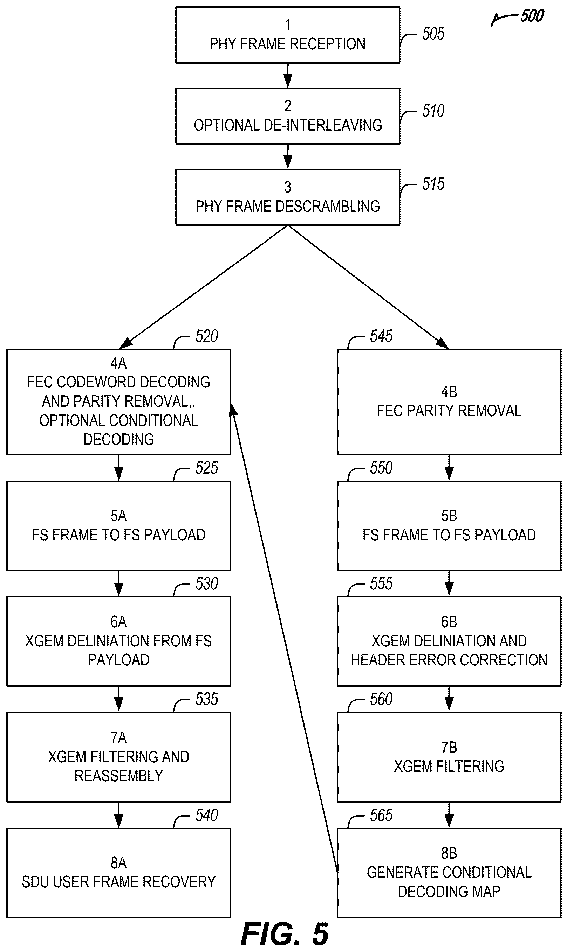

FIG. 5 illustrates an example of a process 500 for ten gigabit passive optical network (XGPON) Encapsulation Method (XGEM) look-ahead for conditionally processing compute resources, according to an embodiment. The process 500 enables a node to look ahead for codewords without implementing the FEC decoder function to create a conditional map without any information from the OLT. A 2nd path (4b FEC parity removal 545-8b generate conditional decoding map 565) is realized that skips the FEC decoder (and operates the remaining processing items (1) physical frame reception 505, (2) optional de-interleaving 510, (3) physical frame descrambling 515, (5a) frame sublayer (FS) frame to FS payload 525, (6a) XGEM delineation from the FS payload 530, (7a) XGEM filtering and reassembly, and (8a) SDU user frame recovery 540-Standard based PHY Frame to SDU Recovery Processing Functions

FEC Codeword Decoding is completed per standard with optional processing of a conditional decoding map 520. Alternate PHY frame processing is completed based on uncorrected data to generate a conditional decoding map at 4b FEC parity removal 545-8b generate conditional decoding map 565.

The secondary path is a parallel processing path that operates on the uncorrected PHY frame data and recovers a conditional decoding map. The PHY frame can be deterministically reconstructed without FEC decoding because the framing is carried in a field with dedicated error correction.

FEC parity is sent in deterministic locations at (4b) FEC parity removal 545 based upon the codeword size/algorithm. No information is used to properly remove the parity other than the pre-determined FEC algorithm utilized on the transport. Furthermore, once the parity has been removed the remaining data is an uncorrected copy of the original data, albeit with errors determined by the physical link. While the errors are unsuitable for recovering user traffic, enough information remains to continue processing a conditional decoding map.

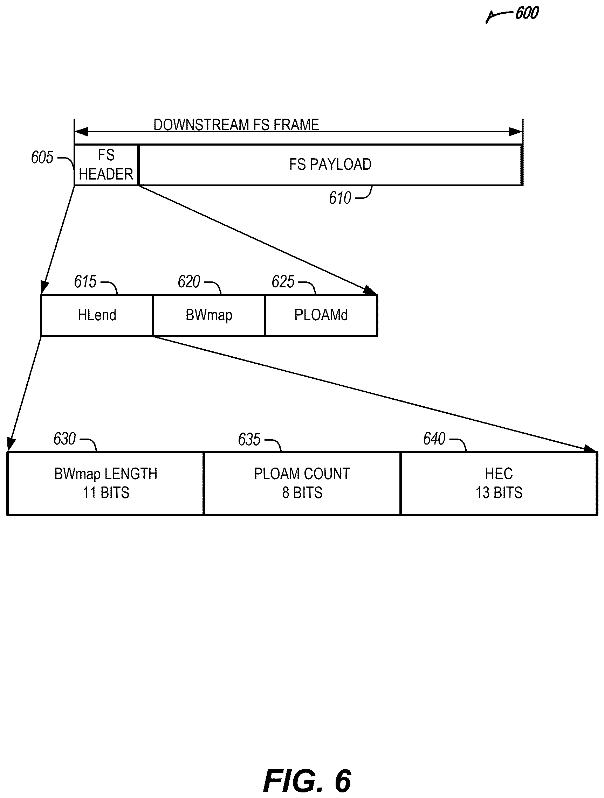

FIG. 6 illustrates and example of a framing sublayer (FS) packet 600 for conditionally processing compute resources, according to an embodiment. FIG. 6 shows the format of the FS packet 600 and how an ONT can recover a FS Payload 610 framing by utilizing the correctable header present in a FS Header 605 data. The FS header 605 comprises a HLend 615 that is a 4-byte structure that controls the size of the variable length partitions within the downstream FS header, a BWmap 620 that is a count that is in a BWmap length 630 field of the HLend 615 structure , and a PLOAMd 625 that is a count that depends on a PLOAM count 635 of the HLend 615 structure . The BWmap length 630 is a number of allocation structures within the BWmap 620 of the HLend 615 structure. The PLOAM count 635 contains a number of PLOAMd 625 messages after BWmap 620 of the HLend 615 structure. The HEC 640 is a hybrid error correction of the HLend 615 structure as a component of the HLend 615 structure. In an example, codewords may be marked for decoding when an XGEM header lookup fails allowing codewords to be decoded when it cannot be determined that the codeword should be ignored. In an example, additional decoder capacity can accommodate uncertainty of XGEM header failures due to high bit-error rate. For example, the FEC decoder may be designed with reserve processing capacity that can be accessed if high bit-error rates are encountered.

Returning to the description of FIG. 5, even though the FEC decoding has not been processed, the header itself has error correction built-in such that the ONT has a high likelihood of correcting the field and properly framing the FS Payload, even in the presence of uncorrected data at (5b) FS frame to FS payload 550.

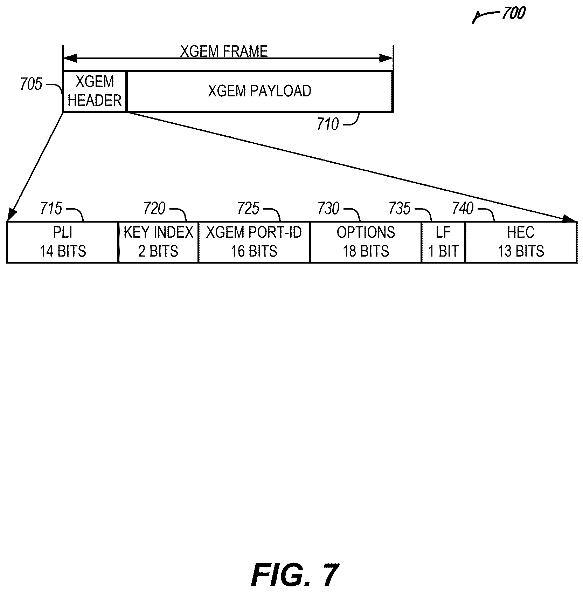

When the FS Payload has been recovered the XGEM delineation state machine begins tracking the XGEM headers that contain variable size payloads at (6b) XGEM delineation and header error correction 555. FIG. 7 illustrates and example of a ten gigabit passive optical network (XGPON) Encapsulation Method (XGEM) packet 700 for conditionally processing compute resources, according to an embodiment. The XGEM packet 700 includes an XGEM header 705 and an XGEM payload 710. The XGEM header 705 comprises a payload length indicator (PLI) 715 that is a length of a service data unit (SDU) fragment in the XGEM payload 710, a key index 720 that identifies an encryption key used to encrypt the XGEM payload 710, an XGEM port identifier (ID) 725 that identifies a port to which the XGEM frame 700 belongs, options 730 that can be reserved for future use, last fragment (LF) 735 that is a single bit indicator of whether or not the fragment is the last fragment in the SDU, and HEC 740 that is an error detection and correction field for the XGEM header 705.

Returning to the description of FIG. 5, within an XGEM header is a HEC field built upon a Bose-Chaudhuri-Hocquenghem (BCH) code that allows two-bit error correction and three-bit error detection. The XGEM state machine relies upon successful BCH decoder matches to maintain delineation in the presence of variable header positions. Although the payload of the XGEM frame is corrupted due to the lack of FEC decoding, (6b) XGEM header delineation 555 can be maintained even in the presence of physical layer errors because the payload size (e.g., PLI) and position of a subsequent XGEM frame is protected and correctable. XGEM payloads can be encrypted but are not relevant in this alternate path because the headers are used to create a conditional decoding map.

When the XGEM delineation state machine has obtained XGEM IDs, the XGEM IDs are checked against a lookup table at (7b) XGEM filtering 560 to specify whether a queried port-id is destined for the ONT or if it can be discarded as one destined for a different ONT. The underlying payload can be reassembled and reconstructed into the original SDU, but since this data is uncorrected by FEC, the original SDU can be corrupted and unusable. However, because the XGEM headers are correctable in the presence of no FEC decoding, the port-id information can still be used for the lookup table.

The output of (7b) XGEM filtering 560 is the result of a lookup table specifying whether a current XGEM (and therefore the current FEC codeword) has relevant data for this ONT. When matches occur, the codeword is marked as relevant and fed to the standard-based corrected path with additional information to process the conditional decoding. Matches that span codeword boundaries have both codewords marked as relevant. When no lookups occur within a codeword it is marked as non-relevant, skip, etc.

In an example, the conditional decoding map can have pre-provisioned static slices. A PHY frame is broken into some number of deterministic codewords. Codewords can be assigned to a static slice where the OLT directs traffic for an ONT to a slice to which the traffic is subscribed. The ONT processes the codewords assigned to its slice allowing a smaller FEC decoder function to be present for dynamic power savings and reduced ASIC size. The OLT insures that XGEM frames begin on the beginning of a slice. Thus, the underlying conditional decoding map is pre-provisioned and static rather than dynamically sent by the OLT. Knowledge of the slice map by the OLT is used so that XGEM frames are sent to the proper slice. In an example, the ASIC may track slice throughput rather than PHY speed. The ASIC may control its resources like a valve by adjusting the resources up or down to match the size of the slice. In an example, the OLT and the ONU may follow a pre-provisioned codeword (e.g., static map, a module, etc.) rather than generating a decoding map dynamically. This reduces processing by enabling the OLT and ONU to follow the pre-provisioned codeword map to perform a look up for a codeword. In an example, the decoding map may be derived from a static map retrieved from a precision timing source (e.g., 1588-2019 - IEEE Standard for a Precision Clock Synchronization Protocol for Networked Measurement and Control Systems by the Institute of Electrical and Electronics Engineers (IEEE), etc.).

The initial one or two codewords of a PON PHY Frame is marked as relevant because the codewords contain critical PLOAM messages and bandwidth allocation maps for upstream transmission. Both the PLOAM messages and bandwidth maps are subjected to FEC correction but are contained within the first couple of code words. The actual size of the PLOAM/BWMAP partition is contained in the FS Header and part of the first corrected codeword. When the PLOAM/BWMAP partitions have passed, the XGEM header based conditional decoding map dictates which codewords are processed and which are skipped.

Because the FEC decoder is presenting the FS Payload with uncorrected data during codewords that were skipped, the XGEM delineation state machine relies upon the same header error correction as discussed in (6b) XGEM delineation and header error correction 555 to maintain alignment at (6a) XGEM delineation and header error correction 530. This remains standard operation and does not deviate from the ITU recommendations. Because the conditional decoding map was calculated on the same uncorrected data there will not be an XGEM frame in need of processing during the skipped codewords.

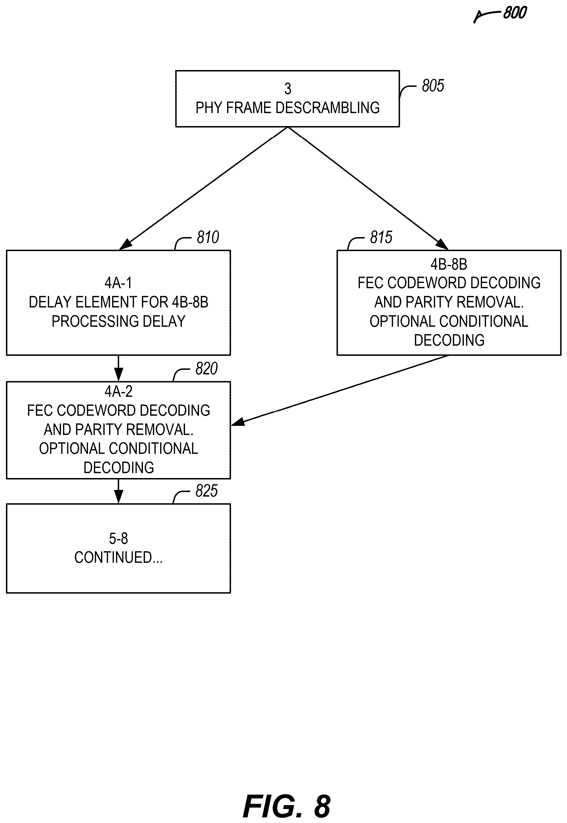

FIG. 8 illustrates an example of a reduced operations process 800 for ten gigabit passive optical network (XGPON) Encapsulation Method (XGEM) look-ahead for conditionally processing compute resources, according to an embodiment. The process 800 uses minimal logic because the FEC Decoder function is not present in this alternate path of an XGEM frame.

A physical frame is descrambled at operation 805. FEC codeword decoding, parity removal, and optional conditional decoding is performed at operation 815. When a conditional decoding map has been created based upon the alternate XGEM processing path (e.g., at operation 815), the existing FEC decoder present on an ONT can become conditional with benefits including dynamic power reduction, smaller ASIC size, etc.

A processing delay can be used if the alternate path conditional decoding maps are utilized at operation 810. Because there is no FEC decoding function, the delay can be a single code-word to give operation 815 time to check XGEM headers contained within a frame. The delay element introduces a delay before conditional decoding can be processed. If no conditional decoding map is provided, operation 810 is bypassed and operation 820 reverts to ITU standard specification to decode all codewords. A pipeline can be used where a decision about whether to decode or skip a codeword is made in real-time and presented to operation 820 just as the data from operation 810 is exiting the pipeline. The delay is deterministic and can be made very small to minimize latency impacts. In an example, the delay element is a buffer that absorbs packet-delay variance from high-speed PHY rate to the reduced rate of the FEC decoder. For very high-speed PONs to low-speed UNIs (e.g., 100G → 1G) for example, this buffer maintains TCP throughput and is sized accordingly.

ONTs that support conditional code windows for conditional decoding can also use header-based conditional decoding. For example, header-based and CDW-based approaches can be implemented on an ONT and can be selectable by the ONT or an operator. For example, the ONT can choose to implement CDW-based conditional decoding on compliant OLTs, and header-based conditional decoding on non-compliant OLTs such that the same benefit can be realized.

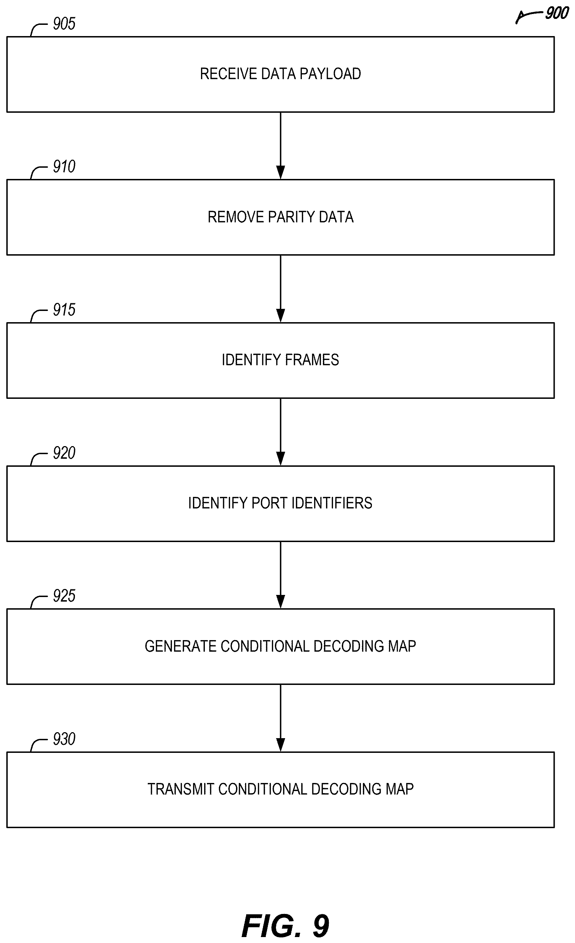

FIG. 9 is a flow diagram of an example method 900 for conditionally processing compute resources, according to an embodiment. The method 900 can provide features as described in FIGS. 1 to 8.

A data payload is received (e.g., at operation 905) (e.g., by the transceiver 450 as described in FIG. 4, etc.). Parity data is removed (e.g., by the FEC parity remover 425 as described in FIG. 4, etc.) from the data payload to generate a codeword dataset (e.g., at operation 910). In an example, a forward error correction algorithm can be applied to the data payload to generate the codeword dataset as an uncorrected copy of the data payload.

Frames are identified (e.g., by the payload framer 430 as described in FIG. 4, etc.) in the codeword dataset (e.g., at operation 915). In an example, a framing sublayer header can be obtained for the data payload and a frame can be identified in the codeword dataset using header data from the framing sublayer header.

The FS header framing is covered by error correction such that the XGEM delineation can achieve framing on the uncorrected receive data for conditional decoding. However, the first codewords that contain the entirety of the FS header can be decoded to properly receive downstream PLOAM messages. This can be true even if there is not a match on an XGEM port-ID. In an example, conditional decoding can begin for codewords subsequent to completion decoding of the FS header codeword. In an example, conditional decoding can use the FS header framing information to determine whether the first one or more codewords that contain the FS header require decoding. Thus, the decoding remains conditional but is determined not by the XGEM Port-ID, but rather it is determined by the contents of the FS header.

Headers of the frames are evaluated (e.g., by the delineator and header error correction engine 435 as described in FIG. 4, etc.) to identify port identifiers for the frames (e.g., at operation 920). A conditional decoding map is generated (e.g., by the conditional decoding map generator 445 in conjunction with the codeword filter 440 as described in FIG. 4, etc.) based on the port identifiers (e.g., at operation 925). In an example, a size of a payload fragment of the codeword dataset and a position of the payload fragment of the codeword dataset can be determined using data extracted from a ten-gigabit passive optical network encapsulation method packet header. The size and the position of the payload fragment can be added to the conditional decoding map based on a determination that the port identifier matches a port identifier for the optical network terminal. In an example, the size of the payload fragment can be determined using a payload length indication field of the ten-gigabit passive optical network encapsulation method packet header. In an example, a frame of the codeword dataset can be identified as a physical layer operation administration and maintenance frame or a bandwidth map frame and a codeword associated with the frame can be added to the conditional decoding map.

The decoding map is transmitted to a conditional decoder to decode codewords included in the conditional decoding map (e.g., at operation 930). In an example, a delay element can be transmitted to the conditional decoder until transmission of the conditional decoding map. The delay element can prevent codeword decoding by the conditional decoder.

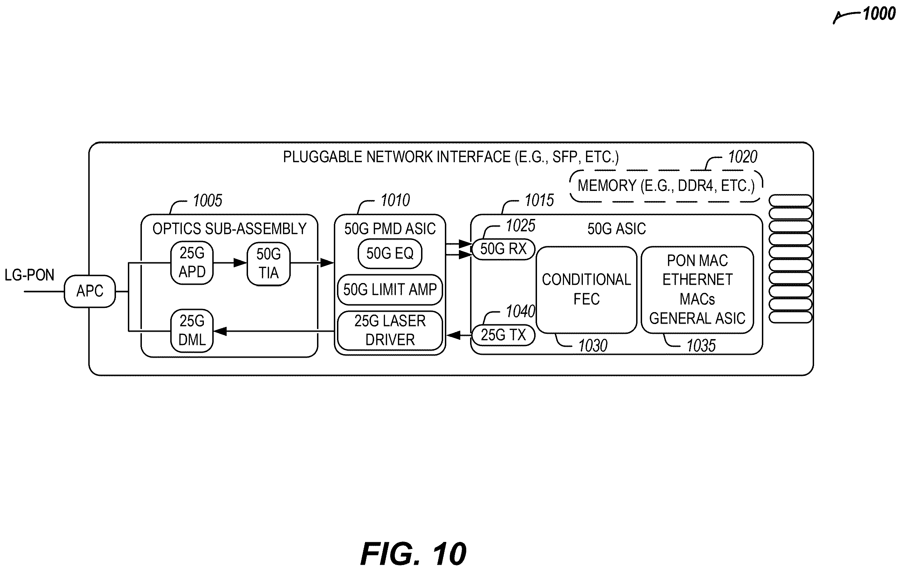

FIG. 10 is a block diagram of an example network interface device 1000 for conditionally processing a compute resource, according to an embodiment. The network interface device 1000 may provide features as described in FIGS. 1-9. The systems and techniques described herein yield smaller ASICs which can be utilized in smaller form factors, such as a small form-factor pluggable (SFP) module, another pluggable network interface, etc. The network interface device 1000 may include an optics sub-assembly 1005 or other media interface that enables the physical transmission of signals on the network medium, a physical medium dependent (PMD) ASIC 1010 that manages bit transmission and receipt using the media interface, a proprietary ASIC 1015 (e.g., a 50-gigabit fiber ASIC, etc.) that provides a variety of specialized functions such as FEC, media access control, AI and ML functions, etc. In some examples, the network interface device 1000 may include memory 1020 (e.g., double data rate 4 memory, etc.).

The proprietary ASIC 1015 may include a variety of components such as a 50gb receive channel, a 25gb transmit channel, a conditional FEC decoder 1030, and a general ASIC including MAC information. The PMD device (e.g., functions of the PMD ASIC 1010, etc.) can be integrated with the conditional FEC decoder 1030 in several ways to create a more efficient and compact optical network unit (ONU) design. The PMD device and the conditional FEC decoder 1030 can be implemented on the same ASIC, allowing for tighter integration and reduced power consumption. This enables direct communication between the PMD functions and the conditional FEC decoder 1030, improving overall system performance.

A unified control logic can be implemented to manage both the physical layer functions and the conditional decoding process by integrating the PMD device with the conditional FEC decoder enabling more efficient decision-making regarding which codewords to decode based on real-time physical layer conditions. Integration enables a more streamlined data flow from the optical receiver to the conditional FEC decoder 1030. For example, the PMD device can directly feed received data and any relevant metadata (e.g., signal quality indicators, etc.) to the conditional FEC decoder 1030 reducing latency and improving overall system responsiveness. Integration enables use of a shared buffer or delay element between the PMD device and the conditional FEC decoder 1030. This buffer can absorb packet-delay variance from the high-speed PHY rate to the reduced rate of the conditional FEC decoder to maintain TCP throughput in high-speed PON to low-speed user network interface (UNI) scenarios.

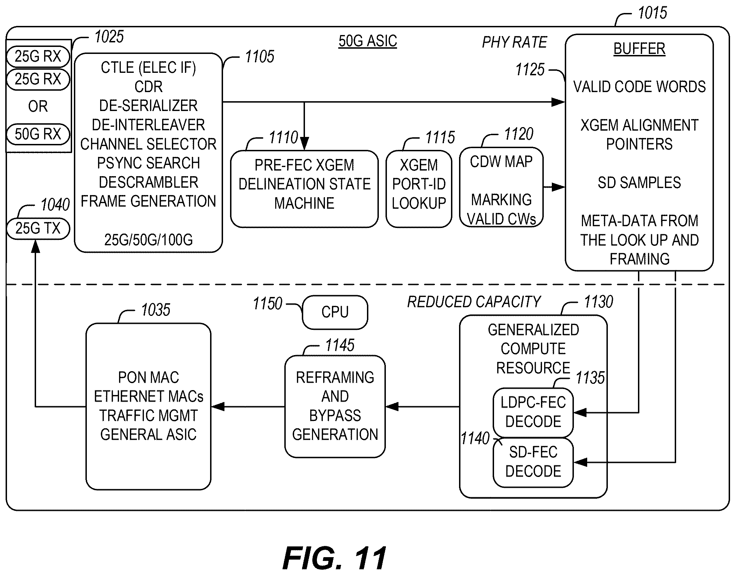

FIG. 11 is a block diagram of an application specific integrated circuit (ASIC) 1015 for conditionally processing a compute resource, according to an embodiment. FIG. 11 illustrates a more detailed view of the proprietary ASIC 1015 shown in FIG. 10. The proprietary ASIC 1015 may include a receive channel 1025, a general ASIC 1035, and a transmit channel 1040 as described in FIG. 10. The proprietary ASIC 1015 can include media control logic 1105, a pre-FEC XGEM delineation state machine 1110, an XGEM port-ID query engine 1115, a CDW mapper 1120, and a buffer 1125 that operate at the PHY rate. The proprietary ASIC 1015 can include a generalized compute resource 1130 that can include FEC decoders such as a LDPC-FEC decoder 1135, a soft decode FEC (SD-FEC) decoder 1140, etc.; a central processing unit 1150; a reframing and bypass generator 1145 that operate at reduced capacity determined based on throughput of a network slice with the general ASIC 1035.

Codeword filtering is performed in conjunction with the CDW mapper 1120 based upon an OLT provided map, ONU self-filtering, etc. In an example, an ONU may have a static filter map pre-programmed for the CDW mapper 1120 enabling the ONU to filter codewords without receipt of a map from the OLT or processing filtering decisions. In this case, the OLT adheres to the static map and enforces the static map. In an example, an ONT can rely upon XGEM header error correction (in place of FEC) to filter codewords. In some examples, precision time protocol may be used for conditional decoding. Rather than the OLT providing conditional decoding maps, or the ONT self-filtering, a time-stamp algorithm is used to determine when to decode and when not to decode. For example, network devices may synchronize their clocks and metadata, or other information may be shared that indicates codewords destined for a recipient based on the synchronized time associated with a codeword.

Under high bit-error-rates, a loss of XGEM delineation may occur. The pre-FEC XGEM delineation state machine 1110 marks codewords for processing if a codeword contains a valid header when delineation loss occurs. This avoids a risk of missed codewords in situations like high bit-error-rates where delineation may occur.

The systems and techniques for conditional decoding apply to soft-decision FEC (SD-FEC) as well as LDPC-FEC. The buffer 1125 includes metadata that includes soft-decision information enabling coding gains to be achieved with smaller implementations that use probabilities rather than hard binary results.

A variety of techniques, alone or in combination, may be used to determine and set compute resource capacity sizing including reserve resource capacity. Slice throughput tracking can be used to track a slice throughput rather than the full PHY speed enabling more efficient resource allocation based on actual traffic demands rather than theoretical maximum capacity. Dynamic resource adjustment may work like a valve, where resource capacity is adjusted up or down to match the size of the slice ensuring that resource capacity is optimized for current traffic conditions. Pre-provisioned static maps can be used by the ASIC in determining resource capacity based on a decreased need for real-time processing as the OLT and ONU can make decisions using the static map rather than generating maps. Buffer sizing may be influenced by packet delay variance based on size of a delay element or buffer needed to absorb the packet-delay variance. This is useful in high-speed PON to low-speed UNI scenarios where the buffer needs to be sized to maintain TCP throughput. Additional compute resource capacity may be reserved for uncertainty. The ASIC can be designed with reserve processing capacity or adjust assigned resource capacity to accommodate uncertainty in XGEM header failures due to high bit-error rates or other errors that may be corrected by adjusting available resources. The additional capacity enables the ASIC to handle unexpected decoding requirements.

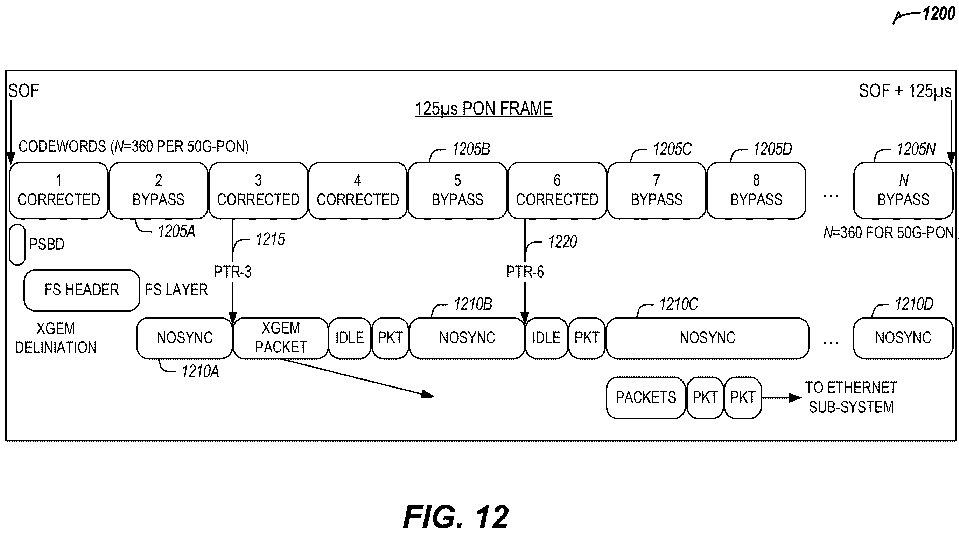

FIG. 12 is a block diagram of frame reconstruction of an example frame 1200 for conditionally processing a compute resource, according to an embodiment. There are several frame reconstruction considerations post conditional decoding. Many codewords will be skipped in a reconstructed frame such as example frame 1200. Reduced rate XGEM delineation skips uncorrected codewords 1205A, 1205B, 1205C, 1205D, and 1205N. A new XGEM delineation state called NO SYNC (e.g., no sync states 1210A, 1210B, 1210C, and 1210D) is introduced to skip through the uncorrected codewords 1205A, 1205B, 1205C, 1205D, and 1205N.

The delay or storage element feeding the FEC decoder contains meta-data about where a valid XGEM header exists (e.g., pointer for codeword three 1215, pointer for codeword six 1220) to allow the new delineation state machine to move from the no sync state back to a header state.

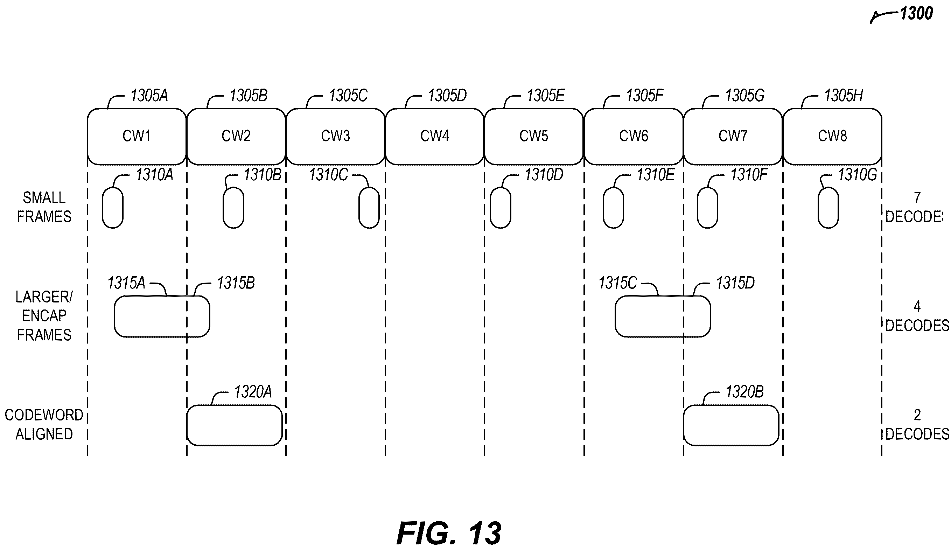

FIG. 13 is a block diagram of that illustrates decoding operations 1300 for various packet configurations for conditionally processing a compute resource, according to an embodiment. Small packet sizes can spread across every codeword resulting in the ASIC decoding all the codewords using FEC compute in the termination ASIC. In the example provided in FIG. 13, there are a set of 8 codewords 1305A, 1305B, 1305C, 1305D, 1305E, 1305F, 1305G, and 1305H. In the example, codeword 1305B and codeword 1305G are meant for the receiving terminal and should be decoded.

Where small frames are used, seven decodes 1310A, 1310B, 1310C, 1310D, 1310E, 1310F, and 1310G are performed due to packets present for each codeword other than codeword 1305D. Large or burst transmissions (e.g., approximately 1500-byte frames, etc.) are present at fewer codewords (e.g., codewords 1305A, 1305B, 1305F, and 1305G) as a result decode operations are reduced to four including decode operations 1315A, 1315B, 1315,C, and 1315D.

An OLT (or router) enabled to use scheduler transmission timeslots or downstream burst uses an inter-frame-gap setting off times that limit how many FEC codewords have frames present resulting in two decode operations (e.g., decode operations 1320A and 1320B).

To enable resource savings in environments with small packets, the packets are aggregated prior to transmission or encapsulated into a tunnel protocol with a set packet-per-second limitation to prevent the conditional decoder from being overloaded. Tunneling can be initiated at the OLT, a broadband network gateway (BNG), Router, another network interface, etc. For example, a plurality of packets can be encapsulated into a single XGEM frame with de-encapsulation preformed in a termination ONT. In an example, an over-the-top encapsulation tunnel header could be used to filter packets rather than XGEM look ups. Encapsulation headers can provide improved error-correction when compared to an XGEM BCH-Decoder enabling the ONT to better filter and limit extra capacity to account for loss-of-delineation. In an example, filtering may use a slice-id, rather than a port-id filter.

Standards-based XGEM encryption encrypts the encapsulation header and unless the packet is being filtered based on the header. Encryption can still be enabled to solving the small-packet-per-second issue. In this case XGEM filtering or static maps are utilized. If encryption is disabled, the tunnel protocol provides over-the-top encryption that provide security for the packet and enables slice security.

XGEM frames sent by the OLT do not necessarily line up with a FEC code word. For example, a 1500byte encapsulation or single frame can span two code words (e.g., the packets associated with decoding operations 1315A, 1315B, 1315C, and 1315D). The address this issue at the OLT, the XGEM frames carrying encapsulated or scheduled traffic are arranged into a single code-word, reducing load on the ONT FEC decoder saving decoder capacity.

While conditional FEC decoding is used as an example herein, it should be understood that the systems and techniques discussed herein are applicable to a variety of conditional compute resources such as artificial intelligence (AI) inference, soft-decision FEC, digital signal processing (DSP), equalizers, etc. The systems and techniques discussed herein enable compute resource sizing to a capacity of a network slice rather than physical capacity resulting in processing hardware with decreased energy consumption, reduced complexity, reduced physical size, etc.

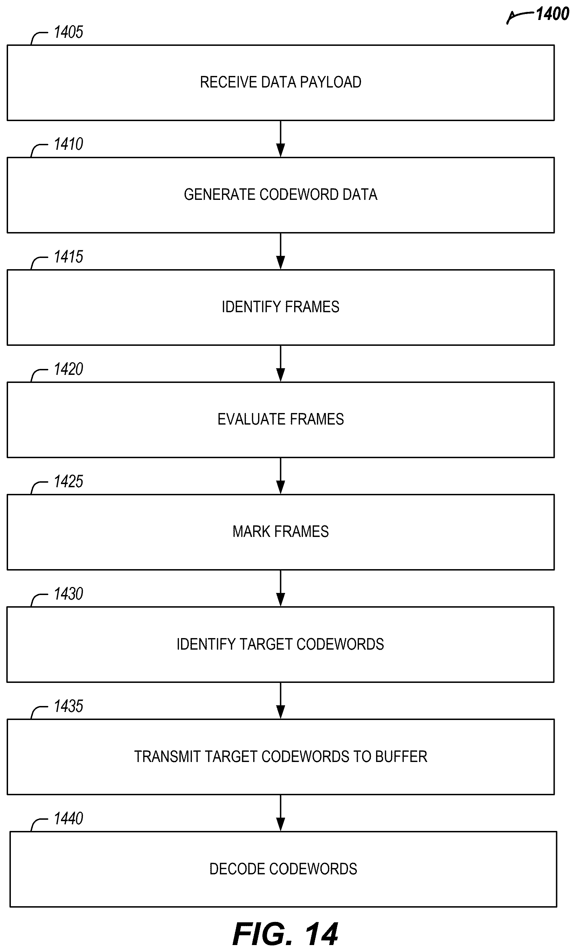

FIG. 14 is a flow diagram of an example method 1400 for conditionally processing a compute resource, according to an embodiment. The method 1400 may provide features as described in FIGS. 1 to 13.

A data payload is received (e.g., at operation 1405). Parity data is removed from the data payload to generate a codeword dataset (e.g., at operation 1410).

Frames are identified in the codeword dataset (e.g., at operation 1415). Headers of the frames are evaluated using a conditional decoding map (e.g., at operation 1420). In an example, the frames may be aggregated prior to evaluation of the headers. In an example, the aggregation may use an inter-frame gap. In an example, the frames (or aggregated frames) may be encapsulated into a single XGPON Encapsulation Method (XGEM) frame prior to generation of the codeword dataset. The frames are marked based on a destination in the headers found in the conditional decoding map (e.g., at operation 1425). A set of target codewords are identified from the frames based on the marking (e.g., at operation 1430). Remaining frames of the frames are discarded that are outside the set of target codewords (e.g., at operation 1435).

The set of target codewords is transmitted to a buffer of a conditional decoder (e.g., at operation 1440). In an example, the buffer may absorb packet-delay variance from a high-speed physical layer rate to a reduced rate of a network slice. Codewords from the buffer are decoded using the conditional decoder (e.g., at operation 1445).

In an example, a compute resource of the optical network terminal is sized according to throughput of a network slice of the optical line terminal. In an example, the compute resource may be sized by tracking the slice throughput and dynamically adjusting a capacity of the compute resource based on the slice throughput. In an example, capacity for a compute resource of the optical line terminal may be increased based on a bit-error-rate of the conditional decoder.

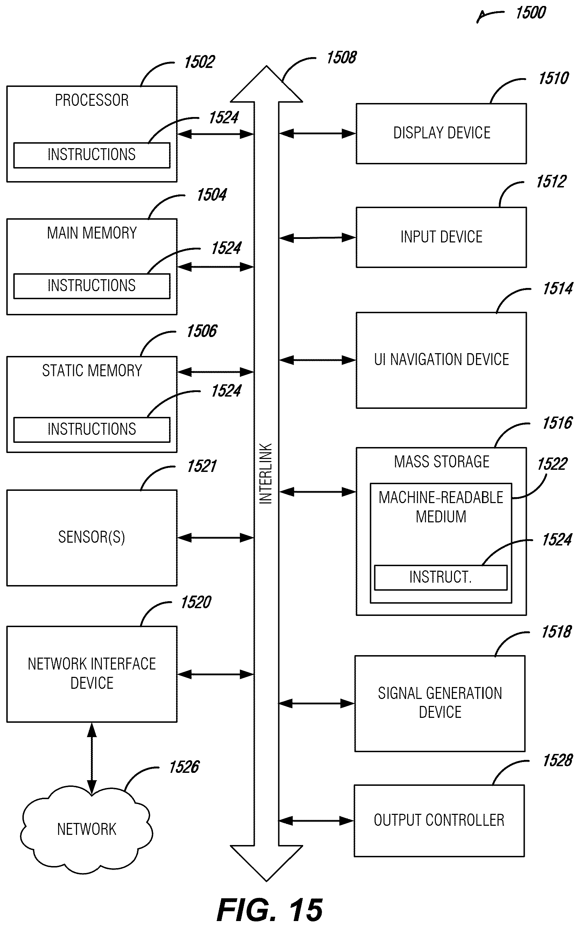

FIG. 15 illustrates a block diagram of an example machine 1500 upon which any one or more of the techniques (e.g., methodologies) discussed herein can perform. In alternative embodiments, the machine 1500 can operate as a standalone device or can be connected (e.g., networked) to other machines. In a networked deployment, the machine 1500 can operate in the capacity of a server machine, a client machine, or both in server-client network environments. In an example, the machine 1500 can act as a peer machine in peer-to-peer (P2P) (or other distributed) network environment. The machine 1500 can be a personal computer (PC), a tablet PC, a set-top box (STB), a personal digital assistant (PDA), a mobile telephone, a web appliance, a network router, switch or bridge, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations.

Examples, as described herein, can include, or can operate by, logic or a number of components, or mechanisms. Circuit sets are a collection of circuits implemented in tangible entities that include hardware (e.g., simple circuits, gates, logic, etc.). Circuit set membership can be flexible over time and underlying hardware variability. Circuit sets include members that can, alone or in combination, perform specified operations when operating. In an example, hardware of the circuit set can be immutably designed to carry out a specific operation (e.g., hardwired). In an example, the hardware of the circuit set can include variably connected physical components (e.g., execution units, transistors, simple circuits, etc.) including a computer readable medium physically modified (e.g., magnetically, electrically, moveable placement of invariant massed particles, etc.) to encode instructions of the specific operation. In connecting the physical components, the underlying electrical properties of a hardware constituent are changed, for example, from an insulator to a conductor or vice versa. The instructions enable embedded hardware (e.g., the execution units or a loading mechanism) to create members of the circuit set in hardware via the variable connections to carry out portions of the specific operation when in operation. Accordingly, the computer readable medium is communicatively coupled to the other components of the circuit set member when the device is operating. In an example, any of the physical components can be used in more than one member of more than one circuit set. For example, under operation, execution units can be used in a first circuit of a first circuit set at one point in time and reused by a second circuit in the first circuit set, or by a third circuit in a second circuit set at a different time.

Machine (e.g., computer system) 1500 can include a hardware processor 1502 (e.g., a central processing unit (CPU), a graphics processing unit (GPU), a hardware processor core, or any combination thereof), a main memory 1504 and a static memory 1506, some or all of which can communicate with each other via an interlink (e.g., bus) 1508. The machine 1500 can further include a display unit 1510, an alphanumeric input device 1512 (e.g., a keyboard), and a user interface (UI) navigation device 1514 (e.g., a mouse). In an example, the display unit 1510, input device 1512 and UI navigation device 1514 can be a touch screen display. The machine 1500 can additionally include a storage device (e.g., drive unit) 1516, a signal generation device 1518 (e.g., a speaker), a network interface device 1520, and one or more sensors 1521, such as a global positioning system (GPS) sensor, compass, accelerometer, or other sensors. The machine 1500 can include an output controller 1528, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.).

The storage device 1516 can include a machine readable medium 1522 on which is stored one or more sets of data structures or instructions 1524 (e.g., software) embodying or utilized by any one or more of the techniques or functions described herein. The instructions 1524 can also reside, completely or at least partially, within the main memory 1504, within static memory 1506, or within the hardware processor 1502 during execution thereof by the machine 1500. In an example, one or any combination of the hardware processor 1502, the main memory 1504, the static memory 1506, or the storage device 1516 can constitute machine readable media.

While the machine readable medium 1522 is illustrated as a single medium, the term "machine readable medium" can include a single medium or multiple media (e.g., a centralized or distributed database, and/or associated caches and servers) configured to store the one or more instructions 1524.

The term "machine readable medium" can include any medium that is capable of storing, encoding, or carrying instructions for execution by the machine 1500 and that cause the machine 1500 to perform any one or more of the techniques of the present disclosure, or that is capable of storing, encoding or carrying data structures used by or associated with such instructions. Non-limiting machine-readable medium examples can include solid-state memories, and optical and magnetic media. In an example, machine readable media can exclude transitory propagating signals (e.g., non-transitory machine-readable storage media). Specific examples of non-transitory machine-readable storage media can include: non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magnetooptical disks; and CD-ROM and DVD-ROM disks.

The instructions 1524 can further be transmitted or received over a communications network 1526 using a transmission medium via the network interface device 1520 utilizing any one of a number of transfer protocols (e.g., frame relay, internet protocol (IP), transmission control protocol (TCP), user datagram protocol (UDP), hypertext transfer protocol (HTTP), etc.). Example communication networks can include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 802.11 family of standards known as Wi-Fi^{®}, LoRa^{®}/LoRaWAN^{®} LPWAN standards, etc.), IEEE 802.15.4 family of standards, peer-to-peer (P2P) networks, 3^{rd} Generation Partnership Project (3GPP) standards for 4G and 5G wireless communication including: 3GPP Long-Term evolution (LTE) family of standards, 3GPP LTE Advanced family of standards, 3GPP LTE Advanced Pro family of standards, 3GPP New Radio (NR) family of standards, among others. In an example, the network interface device 1520 can include one or more physical jacks (e.g., Ethernet, coaxial, or phone jacks) or one or more antennas to connect to the communications network 1526. In an example, the network interface device 1520 can include a plurality of antennas to wirelessly communicate using at least one of single-input multiple-output (SIMO), multiple-input multiple-output (MIMO), or multiple-input single-output (MISO) techniques. The term "transmission medium" shall be taken to include any intangible medium that is capable of storing, encoding or carrying instructions for execution by the machine 1500, and includes digital or analog communications signals or other intangible medium to facilitate communication of such software.

### Additional Notes & Examples

Example 1 is a system for conditionally processing compute resources, comprising: at least one processor; and memory comprising instructions that, when executed by the at least one processor, causes the at least one processor to perform operations to: receive a data payload; remove parity data from the data payload to generate a codeword dataset; identify frames in the codeword dataset; evaluate headers of the frames using a conditional decoding map; mark the frames based on a destination in the headers found in the conditional decoding map; identify a set of target codewords from the frames based on the marking; discard remaining frames of the frames outside the set of target codewords; transmit the set of target codewords to a buffer of a conditional decoder; and decode codewords from the buffer using the conditional decoder.

In Example 2, the subject matter of Example 1 wherein, the buffer absorbs packet-delay variance from a high-speed physical layer rate to a reduced rate of a network slice.

In Example 3, the subject matter of Examples 1-2 includes, the memory further comprising instructions that, when executed by the at least one processor, causes the at least one processor to perform operations to: aggregate the frames prior to evaluation of the headers, wherein the aggregation uses an inter-frame gap.

In Example 4, the subject matter of Examples 1-3 includes, the memory further comprising instructions that, when executed by the at least one processor, causes the at least one processor to perform operations to: encapsulate the frames into a single XGPON Encapsulation Method (XGEM) frame prior to generating the codeword dataset.

In Example 5, the subject matter of Examples 1-4 includes, the memory further comprising instructions that, when executed by the at least one processor, causes the at least one processor to perform operations to: size a compute resource of the optical network terminal according to throughput of a network slice of the optical line terminal.

In Example 6, the subject matter of Example 5 wherein, the instructions to size the compute resource comprises instructions to: track the slice throughput; and dynamically adjust a capacity of the compute resource based on the slice throughput.

In Example 7, the subject matter of Examples 1-6 includes, the memory further comprising instructions that, when executed by the at least one processor, causes the at least one processor to perform operations to: increase capacity for a compute resource of the optical line terminal based on a bit-error-rate of the conditional decoder.

Example 8 is at least one non-transitory machine-readable medium comprising instructions for conditionally processing compute resources that, when executed by at least one processor, causes the at least one processor to perform operations to: receive a data payload; remove parity data from the data payload to generate a codeword dataset; identify frames in the codeword dataset; evaluate headers of the frames using a conditional decoding map; mark the frames based on a destination in the headers found in the conditional decoding map; identify a set of target codewords from the frames based on the marking; discard remaining frames of the frames outside the set of target codewords; transmit the set of target codewords to a buffer of a conditional decoder; and decode codewords from the buffer using the conditional decoder.

In Example 9, the subject matter of Example 8 wherein, the buffer absorbs packet-delay variance from a high-speed physical layer rate to a reduced rate of a network slice.

In Example 10, the subject matter of Examples 8-9 includes, instructions that, when executed by the at least one processor, causes the at least one processor to perform operations to: aggregate the frames prior to evaluation of the headers, wherein the aggregation uses an inter-frame gap.

In Example 11, the subject matter of Examples 8-10 includes, instructions that, when executed by the at least one processor, causes the at least one processor to perform operations to: encapsulate the frames into a single XGPON Encapsulation Method (XGEM) frame prior to generating the codeword dataset.

In Example 12, the subject matter of Examples 8-11 includes, instructions that, when executed by the at least one processor, causes the at least one processor to perform operations to: size a compute resource of the optical network terminal according to throughput of a network slice of the optical line terminal.

In Example 13, the subject matter of Example 12 wherein, the instructions to size the compute resource comprises instructions to: track the slice throughput; and dynamically adjust a capacity of the compute resource based on the slice throughput.

In Example 14, the subject matter of Examples 8-13 includes, instructions that, when executed by the at least one processor, causes the at least one processor to perform operations to: increase capacity for a compute resource of the optical line terminal based on a bit-error-rate of the conditional decoder.

Example 15 is a method for conditionally processing compute resources, comprising: receiving a data payload; removing parity data from the data payload to generate a codeword dataset; identifying frames in the codeword dataset; evaluating headers of the frames using a conditional decoding map; marking the frames based on a destination in the headers found in the conditional decoding map; identifying a set of target codewords from the frames based on the marking; discarding remaining frames of the frames outside the set of target codewords; transmitting the set of target codewords to a buffer of a conditional decoder; and decoding codewords from the buffer using the conditional decoder.

In Example 16, the subject matter of Example 15 wherein, the buffer absorbs packet-delay variance from a high-speed physical layer rate to a reduced rate of a network slice.

In Example 17, the subject matter of Examples 15-16 includes, aggregating the frames prior to evaluating the headers, wherein the aggregation uses an inter-frame gap.

In Example 18, the subject matter of Examples 15-17 includes, encapsulating the frames into a single XGPON Encapsulation Method (XGEM) frame prior to generating the codeword dataset.

In Example 19, the subject matter of Examples 15-18 includes, sizing a compute resource of the optical network terminal according to throughput of a network slice of the optical line terminal.

In Example 20, the subject matter of Example 19 wherein, sizing the compute resource comprises: tracking the slice throughput; and dynamically adjusting a capacity of the compute resource based on the slice throughput.

In Example 21, the subject matter of Examples 15-20 includes, increasing capacity for a compute resource of the optical line terminal based on a bit-error-rate of the conditional decoder.

Example 22 is at least one machine-readable medium including instructions that, when executed by processing circuitry, cause the processing circuitry to perform operations to implement of any of Examples 1-21.

Example 23 is an apparatus comprising means to implement of any of Examples 1-21.

Example 24 is a system to implement of any of Examples 1-21.

Example 25 is a method to implement of any of Examples 1-21.

The above detailed description includes references to the accompanying drawings, which form a part of the detailed description. The drawings show, by way of illustration, specific embodiments that can be practiced. These embodiments are also referred to herein as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The above description is intended to be illustrative, and not restrictive. For example, the above-described examples (or one or more aspects thereof) can be used in combination with each other. Other embodiments can be used, such as by one of ordinary skill in the art upon reviewing the above description. The Abstract is to allow the reader to quickly ascertain the nature of the technical disclosure and is submitted with the understanding that it will not be used to interpret or limit the scope or meaning of the claims. Also, in the above Detailed Description, various features can be grouped together to streamline the disclosure. This should not be interpreted as intending that an unclaimed disclosed feature is essential to any claim. Rather, inventive subject matter can lie in less than all features of a particular disclosed embodiment. Thus, the following claims are hereby incorporated into the Detailed Description, with each claim standing on its own as a separate embodiment. The scope of the embodiments should be determined with reference to the appended claims.

## Claims

1. A system for conditionally processing compute resources, comprising:
at least one processor; and
memory comprising instructions that, when executed by the at least one processor, causes the at least one processor to perform operations to:
receive a data payload;
remove parity data from the data payload to generate a codeword dataset;
identify frames in the codeword dataset;
evaluate headers of the frames using a conditional decoding map;
mark the frames based on a destination in the headers found in the conditional decoding map;
identify a set of target codewords from the frames based on the marking;
discard remaining frames of the frames outside the set of target codewords;
transmit the set of target codewords to a buffer of a conditional decoder; and
decode codewords from the buffer using the conditional decoder.

2. The system of claim 1, wherein the buffer absorbs packet-delay variance from a high-speed physical layer rate to a reduced rate of a network slice.

3. The system of claim 1, the memory further comprising instructions that, when executed by the at least one processor, causes the at least one processor to perform operations to:
aggregate the frames prior to evaluation of the headers, wherein the aggregation uses an inter-frame gap.

4. The system of claim 1, the memory further comprising instructions that, when executed by the at least one processor, causes the at least one processor to perform operations to:
encapsulate the frames into a single XGPON Encapsulation Method, XGEM, frame prior to generating the codeword dataset.

5. The system of claim 1, the memory further comprising instructions that, when executed by the at least one processor, causes the at least one processor to perform operations to:
size a compute resource of the optical network terminal according to throughput of a network slice of the optical line terminal.

6. The system of claim 5, wherein the instructions to size the compute resource comprises instructions to:
track the slice throughput; and
dynamically adjust a capacity of the compute resource based on the slice throughput.

7. The system of claim 1, the memory further comprising instructions that, when executed by the at least one processor, causes the at least one processor to perform operations to:
increase capacity for a compute resource of the optical line terminal based on a bit-error-rate of the conditional decoder.

8. A method for conditionally processing compute resources, comprising:
receiving a data payload;
removing parity data from the data payload to generate a codeword dataset;
identifying frames in the codeword dataset;
evaluating headers of the frames using a conditional decoding map;
marking the frames based on a destination in the headers found in the conditional decoding map;
identifying a set of target codewords from the frames based on the marking;
discarding remaining frames of the frames outside the set of target codewords;
transmitting the set of target codewords to a buffer of a conditional decoder; and
decoding codewords from the buffer using the conditional decoder.

9. The method of claim 8, wherein the buffer absorbs packet-delay variance from a high-speed physical layer rate to a reduced rate of a network slice.

10. The method of claim 8, further comprising:
aggregating the frames prior to evaluating the headers, wherein the aggregation uses an inter-frame gap.

11. The method of claim 8, further comprising:
encapsulating the frames into a single XGPON Encapsulation Method, XGEM, frame prior to generating the codeword dataset.

12. The method of claim 8, further comprising:
sizing a compute resource of the optical network terminal according to throughput of a network slice of the optical line terminal.

13. The method of claim 12, wherein sizing the compute resource comprises:
tracking the slice throughput; and
dynamically adjusting a capacity of the compute resource based on the slice throughput.

14. The method of claim 8, further comprising:
increasing capacity for a compute resource of the optical line terminal based on a bit-error-rate of the conditional decoder.

15. At least one machine-readable medium comprising instructions for conditionally processing compute resources that, when executed by at least one processor, cause the at least one processor to perform the method of any one of claims 8 to 14.
